# FASCICULE DE BREVET EUROPEEN

(11) **EP 3 373 712 B1**
(45) Date de publication et mention de la délivrance du brevet: **29.03.2023**
(21) Numéro de dépôt: 17305254.9
(22) Date de dépôt: 09.03.2017
(51) Int. Cl.: H05K 3/04

(54) **PROCÉDÉ DE DÉPÔT DE TRACES CONDUCTRICES**
VERFAHREN ZUR AUFBRINGUNG VON LEITERBAHNEN
METHOD FOR DEPOSITING CONDUCTIVE TRACES

(43) Date de publication de la demande: 12.09.2018
(73) Titulaire: MGI Digital Technology, 94260 Fresnes (FR); Inkjet Engine Technology, 92190 Meudon (FR)
(72) Inventeur: Abergel, Edmond, 75012 Paris (FR); Gautier La Boulch, Louis, 92190 Meudon (FR); Beges, Clement, 94700 Maisons-Alfort (FR)
(74) Mandataire: De Kezel, Eric

(56) Documents cités:
- EP-A2- 1 736 324
- CA-A1- 2 089 060
- US-A- 4 484 970
- US-A1- 2005 167 035

## Description

La présente invention concerne un procédé de dépôt de traces conductrices sur substrat. Ainsi, l'invention concerne notamment un procédé de dépôt de traces conductrices sur substrat par le dépôt d'un revêtement (ou matière) additionnel, généralement appelé « dorure », sur le substrat. En particulier, la présente invention concerne notamment un procédé d'impression comprenant une étape d'impression d'un motif sur le substrat, de préférence par jet d'encre, suivie d'une étape de « dorure » par contact entre le motif préimprimé à dorer et un dispositif de dépôt de « dorure », tel qu'une feuille métallique de préférence conductrice, par exemple un film multicouches comprenant une feuille métallique de préférence conductrice.

Les techniques de dorure de substrat, par exemple de substrat imprimé, sont bien connues de l'homme du métier. Le principe de base de cette technique repose sur le fait de déposer un revêtement additionnel (i.e., dorure ou matière) sur le substrat, par un dispositif de dépôt de « dorure », par exemple en appliquant/pressant une feuille (portant ledit revêtement ou dorure) sur des zones sélectionnées du substrat de manière à faire adhérer aux zones sélectionnées la partie désirée de la feuille. Cette technique peut par exemple comporter un dépôt d'adhésif sur le substrat selon un motif prédéterminé avant le dépôt du revêtement de personnalisation (par exemple la feuille de dorure) sur l'adhésif déposé sur le substrat. Le dépôt de l'adhésif peut se faire au moyen d'une ou plusieurs techniques, comme par exemple l'impression par jet d'encre, l'impression à base de toner, la sérigraphie ou l'impression offset.

Par exemple, la demande de brevet EP0414362-A2 concerne la formation de traces électriques sur un substrat et, plus particulièrement, la formation de traces électriques sur un substrat au moyen d'une étape de formation d'un motif de circuit par jet d'encre suivi d'une étape d'application d'une fine couche métallique sur le dit motif.

La demande de brevet CA2089060 décrit l'application d'une feuille colorée ou métallique sur du toner imprimé sur un substrat, tel que du papier, à haute vitesse, de manière polyvalente, à l'aide d'un cylindre d'impression rotatif et d'un cylindre de transfert rotatif ayant des parties surélevées chauffées espacées circonférentiellement. Le toner, qui comprend de préférence un composant thermoplastique, est appliqué au papier avec une imprimante appropriée, comme un moteur d'impression MIDAX (dépôt ionique) contrôlé par ordinateur. Le toner peut être chauffé par infrarouge juste avant que le papier ne soit alimenté à la ligne de contact entre les cylindres d'impression et de transfert. La chaleur et la pression appliquées à l'interstice transfèrent l'adhésif et le papier d'aluminium de la bande d'aluminium sur le toner collant, en produisant le papier imprimé désiré.

La demande EP1736324 décrit un procédé qui consiste à fournir un enregistrement de données numériques caractérisant un échantillon et à presser numériquement un agent d'adhérence avec l'échantillon sur une surface d'un substrat (1) en utilisant le dit enregistrement. Une couche métallique ou métallisée est mise en contact avec la surface. L'agent d'adhérence est activé pour coller la couche avec la surface dans une zone d'échantillonnage. La couche est ensuite retirée ; et les zones collées restent sur le substrat.

La technique de dorure est généralement optimisée de manière à favoriser de meilleures performances d'accroche de la feuille de dorure sur le substrat tout en améliorant la qualité et plus particulièrement la finesse du dépôt de dorure sur le substrat. Malgré l'évolution et la précision des techniques de dorure, la Demanderesse a constaté qu'il était très difficile de concilier ces deux conditions avec les techniques de dorure connues. Un des objectifs de la présente invention consiste donc à fournir une technique de dorure qui favorise de meilleures performances d'accroche de la feuille de dorure sur le substrat tout en améliorant la qualité et plus particulièrement la finesse du dépôt de dorure sur le substrat.

De plus, aucune des techniques actuelles ne répond à ce jour aux exigences de l'électronique imprimée et ceci pour de nombreuses raisons parmi lesquelles nous citerons à titre illustratif :
- Une précision insuffisante du motif préimprimé qui se traduit par une imprécision des traces conductrices lors de leur dépose ;
- Un motif préimprimé dont les propriétés adhésives sont insuffisantes lors de l'application de la dorure ;
- Une adhésion imparfaite entre le motif préimprimé et la feuille de dorure ce qui entraine des défauts au niveau du circuit et donc une diminution, voir même une absence de conductivité ;
- Une adhésion de surface de la feuille de dorure sur le substrat en dehors du motif préimprimé ;
- Un arrachage partiel de la couche conductrice lors de l'enlèvement de la feuille de dorure :
- Une épaisseur insuffisante de la couche métallique de la feuille de dorure qui ne permet pas d'obtenir les niveaux de conductivité nécessaire ;
- La présence de couches isolantes venant contaminer la surface de la couche métallique lors du transfert sur le substrat ce qui entraîne une absence de conductivité ;
- Une épaisseur de la couche de transport de la feuille de dorure trop importante qui engendre des dépôts imparfaits des traces de dorure sur le motif préimprimé ;
- Etc....

Enfin, aucune technique ne permet d'imprimer actuellement de manière personnalisable et unique, des traces conductrices et des traces isolantes en un seul passage dans une machine d'impression afin de répondre à certaines particularités de l'électronique imprimée (par exemple pont, condensateur...).

La présente invention vise donc à donner des solutions permettant de pallier à ces inconvénients majeurs de l'art antérieur.

### INVENTION

La présente invention concerne et revendique un procédé de dépôt de traces de matière fonctionnelle conductrice d'électricité sur un substrat dans une machine d'impression comprenant un poste d'impression suivi d'un poste de pose de film selon la revendication 1.

La température de transition vitreuse Tg peut être mesurée par toute méthode appropriée. Nous citerons à titre illustratif la calorimétrie à balayage différentiel (en anglais DSC pour Differential Scanning Calorimetry), qui est une méthode d'analyse thermique très reconnue dans le milieu pour mesurer différentes températures et états de transition.

A titre illustratif, l'échantillon polymère va être soumis à une rampe croissante de température de l'ordre de 10°C/min dont le flux de chaleur est mesuré en Watt. La température de transition vitreuse marque le passage de l'état vitreux de la matière à l'état caoutchouteux qui est un phénomène endothermique. Par conséquent, pour définir la valeur de la Tg, il suffit d'attendre l'observation d'une diminution du flux thermique en fonction de la température puis d'utiliser une méthode tangentielle. La valeur obtenue correspond à la Tg du polymère.

Sans vouloir être restreint par cette explication, la Demanderesse pense que la combinaison de ces caractéristiques de procédé/matières permet de répondre aux objectifs cités ci-dessus dans la description ; à titre illustratif, le choix particulier des matières A (comme composant du produit d'impression (par exemple une encre, un vernis et/ou un toner)) et B (comme composant de la pellicule d'application) représente une caractéristique essentielle de l'invention.

De plus, le procédé revendiqué se différencie de l'art antérieur grâce à sa souplesse d'utilisation et grâce à une réduction des temps de fabrication ainsi que des coûts correspondants, ce qui le rend particulièrement attractif, en particulier pour l'électronique imprimée, par exemple la fabrication de circuits imprimés.

La présente invention se rapporte en particulier aux techniques d'impression par jet d'encre en relief du motif d'impression, par exemple à l'aide de têtes d'impression piézo-électriques, adaptées en fonction du produit d'impression (par exemple de l'encre et/ou vernis d'impression utilisé).

Les films utilisés dans le cadre de la présente invention comprennent au moins une pellicule d'application comprenant une matière B thermoplastique, une pellicule de matière fonctionnelle et une couche de transport. L'homme de l'art dénomme généralement ce type de film par l'expression « feuille de dorure ». Ainsi, les feuilles de dorure (films) utilisées dans le cadre de la présente invention sont constituées de plusieurs pellicules superposées comprenant à titre d'exemple non limitatif :
- une pellicule d'application comprenant une matière B,
- au moins une pellicule de matière fonctionnelle conductrice d'électricité,
- une pellicule optionnelle de protection,
- une pellicule optionnelle de décollement, et
- au moins une couche de transport qui permet le transport des autres couches.

Il est évident pour l'homme du métier que les mots « dorure » et « dorer » utilisés dans la présente invention ne sont pas limités à l'utilisation de feuille d'or et que n'importe quel dispositif de « dorure » peut être employé. Ces termes couvrent bien entendu tous les types de feuilles décoratives (parfois également appelées feuilles métalliques) parmi lesquels on peut citer à titre d'exemples illustratifs et non limitatifs, l'aluminium, le chrome, l'or, l'argent, le cuivre ou même des sels de métaux optiquement actifs. En général, on utilise une feuille de dorure pressée contre le substrat à personnaliser, et la présente demande désigne donc par ce terme l'utilisation générale d'un dispositif de dorure. Toutefois, afin d'éviter tout problème d'interprétation, la Demanderesse a préféré utiliser le mot « film » (comprenant entre autres une pellicule de matière fonctionnelle) dans la présente description et dans les revendications.

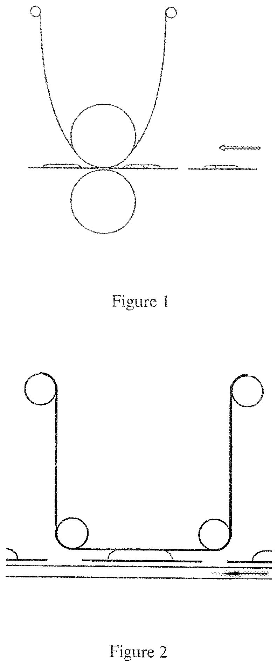

Les figures 1 à 3 illustrent certains modes de réalisation de la présente invention.

L'étape d'application du film sur le substrat dans des conditions de pression et de température entraînant la co-adhésion sélective entre le produit d'impression et la pellicule d'application du film (en particulier entre la matière A du produit d'impression et la matière B de la pellicule d'application du film) peut être effectuée selon toute méthode appropriée. A titre illustratif, on citera l'utilisation
- d'un ou plusieurs ensembles de rouleaux de pincement tels que décrits dans la figure 1 ;
- d'un ou plusieurs rouleaux de pression tels que décrits dans la figure 2.

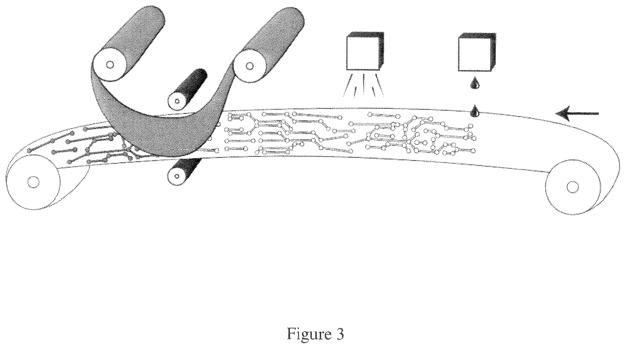

La figure 3 illustre un mode de réalisation du procédé selon la présente invention avec le poste d'impression suivi du poste de dépose de film.

### FILM - composition et propriétés

Les films utilisés dans le cadre de la présente invention sont de préférence constitués de plusieurs pellicules superposées comprenant à titre d'exemple non limitatif et non exhaustif dans l'ordre d'accroche au substrat à recouvrir :
- une pellicule d'application comprenant une matière B,
- suivie d'au moins une pellicule de matière fonctionnelle conductrice d'électricité,
- suivie d'une pellicule optionnelle de protection,
- suivie d'une pellicule optionnelle de décollement, et
- finalement suivie d'au moins une couche de transport qui permet donc le transport des autres couches.

Les films utilisés dans le cadre de la présente invention sont généralement fournis sous la forme de rouleau de largeur sensiblement équivalente à la dimension transversale du substrat.

### Couche de transport

La couche de transport permet le transport des autres couches constitutives du film et, en particulier, de la pellicule de matière fonctionnelle et de la pellicule d'application conformes à la présente invention. Son rôle est donc principalement celui de véhiculer les autres couches constitutives du film jusqu'à la dépose finale de la pellicule d'application et de la pellicule de matière fonctionnelle conformes à la présente invention.

L'épaisseur de cette couche est généralement comprise entre 5 et 50µm. Une épaisseur plus importante a tendance à limiter le transfert thermique nuisant au taux de transfert. Une épaisseur plus faible amène de nombreuses difficultés dans la gestion des tensions. A titre illustratif et non limitatif, la couche de transport peut être composée de films de polyester (PET). Ces derniers peuvent être co-extrudés, de différentes structures, traités en surface, etc.

Les traitements de surfaces peuvent concerner du corona, du plasma, du silicone, de l'acrylique, du polyester, etc.

En fonction de leur nature, les films PET permettront un étalement plus ou moins performant ainsi qu'une adhésion différente avec les couches inférieures du film.

### Pellicule de décollement

La pellicule de décollement (optionnelle mais préférée), plus reconnue sous le terme anglais de « release layer » (ou pellicule de libération) permet l'optimisation du détachement de la couche de transport du reste du film lors de son application. Le grammage de cette pellicule n'est généralement pas quantifiable puisque son épaisseur est de préférence inférieure à 0,1 µm.

Lors de l'application d'une certaine température et pression, le dépassement de sa température de fusion va fluidifier et vaporiser une partie de la couche créant ainsi un détachement. En fonction de sa nature, des traces de la pellicule de décollement vont se retrouver soit sur la couche de transport (par exemple le PET), soit sur la surface de la couche située en dessous, soit sur les deux couches.

Dans la présente invention, les restes de la pellicule de décollement se trouveront de manière préférentielle sur la couche de transport (par exemple le PET) afin de ne pas contaminer la surface de la pellicule de matière fonctionnelle. Dans un mode particulier d'exécution selon la présente invention, la pellicule de décollement comprend et/ou est constituée de matière conductrice d'électricité, par exemple de polymères conducteurs ; en effet, dans ce mode particulier, toute contamination de la pellicule de matière fonctionnelle par la pellicule de décollement n'aura pas d'influence néfaste sur la conductivité recherchée.

La pellicule de décollement peut aussi avantageusement comprendre ou être constituée de cires solubles dans des solvants, de cires en émulsion, de cires naturelles, de cires siliconées, et/ou de cires synthétiques, etc.

A titre illustratif et non limitatif, la pellicule de décollement peut être enduite par le biais des techniques d'impression classiques telles que l'héliogravure, la flexographie, le reverse, etc.

### Pellicule de protection

La pellicule de protection (optionnelle) est aussi appelée de laquage et/ou de couleur (car elle peut aussi comprendre tout type de colorant et/ou pigment et/ou agent de matage ou brillant). Cette pellicule de protection peut être caractérisée par de nombreuses propriétés en fonction de l'utilisation recherchée, que ce soit des propriétés de résistance chimique et/ou physique. Cette pellicule est le plus souvent composée de vernis bi-composant, de résines acryliques, de résines polyesters, de résines hydroxylées, et/ou de dérivées cellulosique, etc. Toutes ces familles de matières constitutives de la pellicule de protection sont en général des polymères organiques qui sont donc considérés comme des isolants. Ainsi, selon un mode particulier d'exécution de la présente invention, le film ne comprend pas de pellicule de protection afin de préserver les caractéristiques conductrices de la pellicule de matière fonctionnelle et d'éviter ainsi son isolation. Dans un mode particulier d'exécution selon la présente invention, la pellicule de protection comprend et/ou est constituée de matière conductrice d'électricité, par exemple de polymères conducteurs ; en effet, dans ce mode particulier, la pellicule de protection n'aura pas d'influence néfaste sur la conductivité recherchée. L'épaisseur de cette couche avoisine habituellement le plus souvent des valeurs comprises entre 2 µm et 3µm.

Tous les films commerciaux possèdent une couche protective à base de polymères non conducteurs, ce qui les rend impropres à leur utilisation dans toute application où la conductivité est recherchée car il en résulte une impossibilité à faire circuler le courant électrique.

A titre illustratif et non limitatif, la pellicule de protection peut être enduite par le biais des techniques d'impression classiques telles que l'héliogravure, la flexographie, et/ou le reverse, etc.

### Pellicule de matière fonctionnelle

Dans l'exécution selon la présente invention, le principal rôle recherché pour la pellicule de matière fonctionnelle est sa conductivité. Cette dernière doit en effet atteindre des valeurs adaptées au marché de l'électronique imprimée. A titre illustratif, la pellicule de matière fonctionnelle peut être caractérisée par une résistance de surface (sheet résistance en anglais) inférieure à 1 Ω/□ (ohm par carré, en anglais ohm/sq), ce qui est particulièrement pertinent pour le domaine des OLED. Cette résistance de surface peut être mesurée par toute méthode appropriée ; nous citerons à titre illustratif la méthode 4 pointes qui permet de réaliser cette mesure en utilisant un générateur qui envoie un courant entre les pointes 1 et 4, en simultané la tension circulant entre les pointes 2 et 3 est mesurée. Il suffit ensuite d'appliquer la loi d'Ohm Tension=Résistance/Intensité pour obtenir la résistance entre les pointes 2 et 3.

Cette pellicule peut donc avantageusement comprendre et/ou être constituée de toute matière conductrice d'électricité. Par exemple, cette pellicule peut être composée de divers métaux déposés par le biais de plusieurs techniques comme le sputtering, l'E-Beam, et/ou l'évaporation thermique sous vide, etc. Les métaux candidats à une telle application sont à titre illustratif le cuivre, l'argent, l'étain, le chrome, l'or, l'aluminium, et/ou les alliages, etc.

Ainsi, selon un mode d'exécution préféré de la présente invention, la matière fonctionnelle de la pellicule de matière fonctionnelle est conductrice d'électricité ; elle peut avantageusement comprendre et/ou être constituée de cuivre et/ou d'argent, et/ou d'étain et/ou de chrome et/ou d'or et/ou d'aluminium, et/ou d'alliages conducteurs.

L'épaisseur de la pellicule de matière fonctionnelle dans un film commercial se situe en général en dessous de 100 nm. Dans un mode d'exécution particulier selon la présente invention, la pellicule de matière fonctionnelle a une épaisseur d'au moins 200 nm, par exemple au moins 500 nm afin d'assurer une conductivité acceptable ; en général la dite épaisseur a comme limite supérieure 3µm, bien que des épaisseurs supérieures soient envisageables. L'augmentation de l'épaisseur de la pellicule de matière fonctionnelle peut effectivement engendrer des problématiques de fragilité du film car le matériau métallique n'est pas aussi flexible que la matrice organique composant un polymère.

Dans un mode d'exécution particulier selon la présente invention, la pellicule de matière fonctionnelle est constituée de polymères conducteurs. Dans cette variante, son épaisseur variera de préférence entre 1µm et 3µm afin d'assurer une conductivité minimale. A titre illustratif et non limitatif, la pellicule de matière fonctionnelle de polymères conducteurs peut être enduite par le biais des techniques d'impression classiques telles que l'héliogravure, la flexographie, et/ou le reverse, etc.

Dans un mode d'exécution particulier selon la présente invention, la pellicule de matière fonctionnelle est caractérisée par une résistance inférieure à 100 Ω, par exemple inférieure à 50 Ω, et de préférence inférieure à 5 Ω. Cette résistance peut être mesurée par toute méthode appropriée ; nous citerons à titre illustratif l'utilisation d'un multimètre en mode Ohm. Ceci permet de mesurer la résistance d'une surface.

### Pellicule d'application

La pellicule d'application qui est généralement absente dans la plupart des applications de film connues à ce jour dans le domaine de la dorure de motifs pré imprimés se réalisant à froid est indispensable dans la présente invention. Son épaisseur est généralement comprise entre 2 et 10µm.

Une caractéristique essentielle de la présente invention réside dans le fait que la pellicule d'application comprend et/ou est constituée d'une matière B thermoplastique, par exemple un polymère thermoplastique B. Dans un mode d'exécution particulier selon la présente invention, la pellicule d'application comprend au moins 50% en poids de la matière B thermoplastique, par exemple au moins 70% en poids, de préférence au moins 80% en poids.

Selon un mode d'exécution particulier de la présente invention, la pellicule d'application comprend donc une matrice de matière B thermoplastique (par exemple de polymère thermoplastique B) et est caractérisée par une température de transition vitreuse Tg telle que cette pellicule soit
- sèche au toucher à température ambiante, et
- thermoréactivable, c'est-à-dire qu'elle possède un comportement thermoplastique à partir duquel la pellicule d'application (et à fortiori la matière B qu'elle contient) va devenir ductile/malléable et développer ainsi une propriété d'adhésion de surface lorsque la température de traitement (et en particulier la température d'application lors de l'étape d'application du film dans le poste de pose du film) est supérieure à cette Tg.

Ainsi, dans un mode d'exécution particulier de la présente invention, la matière B thermoplastique est caractérisée par une valeur de Tg comprise entre 0°C et 200°C, par exemple entre 60°C et 130°C, par exemple entre 80°C et 120°C.

Dans un mode d'exécution particulier de la présente invention, en plus de la matière B, la pellicule d'application peut également comprendre d'autres matières telles que par exemple des matières inertes (par exemple des charges inorganiques). Comme ces autres matières ont en général peu d'influence sur la Tg de l'ensemble de la matière constituant la pellicule d'application, la Tg de la dite pellicule d'application est très proche de celle de la matière B.

Ainsi, dans un mode d'exécution particulier de la présente invention, la pellicule d'application est caractérisée par une valeur de Tg comprise entre 0°C et 200°C, par exemple entre 60°C et 130°C, par exemple entre 80°C et 120°C. La mesure de la Tg de la pellicule d'application sera avantageusement effectuée au moyen de la méthode DSC indiquée ci-avant dans la description - l'échantillon utilisé pour la mesure pourra avantageusement provenir de la matière constituant la pellicule d'application avant la fabrication du film correspondant.

Selon un mode d'exécution particulier de la présente invention, la matrice de polymère (la matière B) de la pellicule d'application présente une affinité particulière avec la matière A du produit d'impression. Cette affinité peut se traduire de différentes manières dont nous citerons à titre illustratif :
- le fait que la matière B contienne et/ou est constituée d'une résine appartenant à une nature chimique qui est également présente dans la matière A du produit d'impression ; à titre illustratif et non limitatif, cette nature chimique sera sélectionnée parmi un groupe nucléophile (comprenant de l'oxygène et/ou de l'azote), un groupe hydroxyle et/ou un groupe azoté ; et/ou
- qu'au moins une des résines soit présente à la fois dans la matière B du film d'application et dans la matière A du produit d'impression et soit une résine acrylique, par exemple une résine acrylique similaire et/ou identique ; et/ou
- qu'au moins une des résines soit présente à la fois dans la matière B du film d'application et dans la matière A du produit d'impression et soit une résine cétonique, par exemple une résine cétonique similaire et/ou identique ; et/ou
- qu'au moins une des résines soit présente à la fois dans la matière B du film d'application et dans la matière A du produit d'impression et soit une résine aldéhyde, par exemple une résine aldéhyde similaire et/ou identique ; et/ou
- qu'au moins un des ingrédients soit présent à la fois dans la matière B du film d'application et dans la matière A du produit d'impression et soit de type cellulosique : par exemple un ingrédient consistant en de l'acétate propionate de cellulose, et/ou de l'acétate butyrate de cellulose, et/ou de l'acétate de cellulose, et/ou de la nitrocellulose.

Selon un mode d'exécution particulier de la présente invention, la matrice de polymère (la matière B) de la pellicule d'application peut être un polymère en phase solvant ou en phase aqueuse.

Sans vouloir être restreint par cette explication, la Demanderesse pense que cette partie commune entre au moins un des composants de la matière A et un des composants de la matière B va permettre de créer une affinité chimique entre ces deux matières lors de leur mise en contact grâce à leurs caractéristiques intrinsèques et grâce aux conditions de mise en contact. Cette affinité est responsable de la dépose sélective puisque la pellicule d'application comprenant la matière B va se déposer seulement sur la matière A et non sur le reste du substrat. Un film qui n'intègrerait pas cette partie commune pourrait soit contaminer, soit se déposer entièrement sur tout le substrat de manière non sélective, soit ne pas se déposer de manière précise et sélective sur le motif du produit d'impression puisque le transfert ne sera pas opérationnel.

A titre illustratif et non limitatif, la pellicule d'application peut être enduite par le biais des techniques d'impression classiques telles que l'héliogravure, la flexographie, le reverse, etc.

### PRODUIT D'IMPRESSION, MATIERE A- composition et propriétés

Une caractéristique essentielle de la présente invention réside dans le fait que le produit d'impression comprend une matière thermodurcissable et une matière A thermoplastique, par exemple un polymère thermoplastique A. Ce produit d'impression préimprimé sur le substrat est garant du design de la future dorure. En fonction de sa composition, le film va ou non se transférer sur le substrat. Il est indispensable que le transfert entre le film et le motif préimprimé soit sélectif, c'est-à-dire seulement au niveau du motif (et donc du produit d'impression préimprimé) favorable au transfert et non directement sur le substrat.

A titre illustratif et non limitatif, ce produit d'impression peut être composé de toner et/ou d'encre et/ou d'un vernis ; il peut être isolant ou conducteur en fonction de l'application visée.

A titre illustratif et non limitatif, dans le cas d'un vernis, celui-ci peut être de nature solvantée, aqueuse ou UV. Lorsqu'il est de nature UV, il peut être réticulé à l'aide de LED et/ou de rayonnements UV.

Selon un mode d'exécution particulier et préféré de la présente invention, le produit d'impression est de type encre UV et/ou vernis UV comprenant une matière thermodurcissable ainsi que la matière thermoplastique A. Selon un mode d'exécution particulier et préféré de la présente invention, le produit d'impression préimprimé (et donc le motif préimprimé) est réticulé avant mise en contact avec le film. Cela peut se traduire par le fait que le réseau polymérique du produit d'impression est à son optimum en terme de densité tridimensionnelle par le biais de la réaction de tous les sites de photo-initiateurs. Cela peut également se traduire par un comportement thermodurcissable, c'est-à-dire que la partie thermodurcissable du vernis ne possède plus de température de transition vitreuse Tg mais seulement une température de destruction ; ainsi, ce polymère thermodurcissable présent dans le vernis ne deviendra jamais mou et ne développera pas de surface collante car il sera totalement sec au touché.

Ainsi, selon certains modes de réalisation préférés de la présente invention, le procédé revendiqué comprend, après l'étape d'impression du produit d'impression et avant l'étape d'application du film, une étape d'activation (par exemple au moyen de rayons UV) permettant de réticuler le produit d'impression (l'encre et/ou le vernis).

L'ajout dans le produit d'impression d'une matière A thermoplastique permet d'atteindre les objectifs d'accroche sélective entre le substrat et le film. A titre illustratif, la sélection d'une matière A appartenant à une nature chimique analogue à la matière B présente en partie dans la pellicule d'application du film, va modifier le comportement du produit d'impression ; ce dernier va devenir en partie thermoplastique puisque la matière A thermoplastique va s'immiscer dans le réseau polymère initialement thermodurcissable. Ainsi, lors de l'application du film sur le produit d'impression préimprimé et, de préférence pré-réticulé, un transfert total et sélectif va s'opérer par le biais de l'affinité des matières A et B et grâce aux conditions de mise en contact.

Un dépôt de couches fonctionnelles sélectif peut donc se réaliser grâce, entre autres, à cette affinité entre la matière A et la matière B.

Ainsi, selon un mode d'exécution de la présente invention, la matière thermoplastique A du produit d'impression est
- thermoréactivable (c'est-à-dire qu'elle possède un comportement thermoplastique), et
- devient ductile/malléable et développe une propriété d'adhésion de surface lors de l'étape d'application du film dans le poste de pose du film (lui-même thermoréactivable).

Ceci permet donc de développer une propriété d'adhésion de surface entre le produit d'impression et la pellicule d'application grâce aux matières A et B lorsque la température de traitement (et en particulier la température d'application du film lors de l'étape d'application du film dans le poste de pose du film) est supérieure aux Tg des matières A et B.

Dans un mode d'exécution particulier selon la présente invention, le produit d'impression comprend au moins 5% en poids de matière A thermoplastique, par exemple au moins 10 % en poids, de préférence au moins 15% en poids. Même si des concentrations élevées en matière A thermoplastique sont envisageables, le produit d'impression comprendra de préférence moins de 40% en poids, par exemple moins de 30% en poids, de préférence moins de 25% en poids de matière A thermoplastique.

Ainsi, dans un mode d'exécution particulier selon la présente invention, le produit d'impression comprend au moins 60% en poids, par exemple au moins 70% en poids, de préférence au moins 75% en poids de matière thermodurcissable.

Ainsi, dans un mode d'exécution de la présente invention, la matière A thermoplastique est caractérisée par une valeur de Tg inférieure à 60°C, par exemple inférieure à 50°C, de préférence inférieure à 40°C. Selon un mode d'exécution particulier de la présente invention, et comme décrit plus en détails ci-après dans la description, les matières A du produit d'impression et B de la pellicule d'application seront sélectionnées de manière à ce que la Tg de la matière A soit inférieure à la Tg de la matière B.

Comme le produit d'impression ne comprend que des quantités limitées de matière A thermoplastique, il est évident que la Tg du produit d'impression aura après dépôt (et réticulation) une valeur qui sera différente de la Tg de la matière A thermoplastique comprise dans ledit produit.

Ainsi, dans un mode d'exécution particulier de la présente invention, le produit d'impression est caractérisé par une valeur de Tg comprise entre 0°C et 200°C, par exemple entre 50°C et 120°C, par exemple entre 65°C et 90°C, de préférence entre 70 et 80°C. La mesure de la Tg de la pellicule du produit d'impression sera avantageusement effectuée au moyen de la méthode DSC indiquée ci-avant dans la description - l'échantillon utilisé pour la mesure pourra avantageusement provenir de la matière constituant le produit d'impression après impression et réticulation. Selon un mode d'exécution particulier de la présente invention, et comme décrit plus en détails ci-après dans la description, le produit d'impression et la pellicule d'application seront de préférence caractérisés en ce que la Tg du produit d'impression soit inférieure à la Tg la pellicule d'application.

### IMPRESSION DU MOTIF - conditions

La présente invention est donc caractérisée en ce que le procédé revendiqué permet l'obtention d'un substrat comprenant la pellicule d'application du film sélectivement co-adhérée au produit d'impression du motif et formant ainsi, grâce à la pellicule de matière fonctionnelle, les traces de matière fonctionnelle selon le dit motif. Le dit motif (du produit d'impression) peut être imprimé par toute méthode appropriée. On citera à titre illustratif et non limitatif la sérigraphie, le jet d'encre, etc... Selon un mode d'exécution particulier et préféré de la présente invention, le produit d'impression est imprimé par une impression jet d'encre. Cette impression jet d'encre permet d'imprimer en relief des zones destinées à être recouvertes ou non, en fonction de la composition du produit d'impression et plus particulièrement de la présence ou non de la matière A, par la pellicule de matière fonctionnelle (par exemple le film de dorure). La dorure se déposera donc de manière sélective. L'impression par jet d'encre est bien connue de l'Homme de l'art.

Les zones (et donc le motif) peuvent avantageusement être toutes sortes de formes, par exemple des circuits imprimés, des points, des lettres et/ou toutes autres formes géométriques quelconques ; elles peuvent être constituées de différentes matières, par exemple d'encres et/ou de vernis et/ou de toner.

L'épaisseur du produit d'impression imprimé peut avantageusement être très variable ; on citera à titre illustratif et non limitatif des épaisseurs comprises entre 5µm et 200µm.

En fait, le relief des motifs et donc des zones destinées à être recouvertes d'une feuille de dorure représente de préférence une épaisseur de l'ordre du micron, de préférence supérieure à cinq microns, ou même supérieure à dix microns. Cette épaisseur - de quelque matière que ce soit préalablement déposée sur le substrat ; par exemple du vernis et/ou de l'encre - est généralement inférieure au millimètre pour l'impression en relief. Toutefois, la présente invention pourrait également s'appliquer à des substrats ayant été imprimés par la technologie 3D au moyen d'impression à jet d'encre (et/ou vernis) par couches successives et présentant ainsi des épaisseurs pouvant aller jusqu'à plusieurs centimètres, par exemple moins de 2 cm.

Le substrat peut être sélectionné parmi un grand nombre de matière et ne pas être considéré comme limité aux matières fréquemment utilisées dans les dispositifs standards d'impression et/ou de personnalisation tels que les substrats papier, carton et plastique. On citera à titre d'exemples non limitatifs le métal, le papier, le tissu non tissé, le plastique, par exemple une résine copolymère méthacrylique, du polyester, du polycarbonate, du polyéthylène, du polypropylène, et/ou du chlorure de polyvinyle, ou même les matériaux de type cellulosique tels que, par exemple, le bois, le contreplaqué ou les matériaux cristallins tels que le verre ou les céramique, par exemple les matériaux complexes comprenant un ou plusieurs de ces composants comme par exemple les briques de lait.

Selon la présente invention, le substrat (feuille, carte, etc.) se présente généralement sous une forme rectangulaire ou carrée. Cette feuille se déplace, en général grâce à un système de transport de substrats dans une machine d'impression, le long d'un chemin de transport orienté selon un axe longitudinal depuis au moins un magasin d'entrée fournissant les substrats imprimables et/ou personnalisables, jusqu'à au moins un magasin de sortie recevant les substrats imprimés et/ou personnalisés, et donc recouverts des traces de matière fonctionnelle conformément à la présente invention. Les « bords latéraux » du substrat sont les deux bords situés de part et d'autre de cet axe longitudinal; les bords avant et/ou arrière sont ses bords transversaux. Le substrat peut également se présenter sous la forme de bobine dans une machine de type bobine-bobine.

### APPLICATION DU FILM

L'étape d'application du film sur le substrat dans des conditions de pression et de température entraînant la co-adhésion sélective entre le produit d'impression et la pellicule d'application du film (en particulier entre la matière A du produit d'impression et la matière B de la pellicule d'application du film) peut être effectuée selon toute méthode appropriée. A titre illustratif, on citera l'utilisation
- d'une ou plusieurs plaques qui viennent presser le film sur le substrat ;
- d'un ou plusieurs ensembles de rouleaux de pincement tels que décrits dans la figure 1 ;
- d'un ou plusieurs rouleaux de pression tels que décrits dans la figure 2.

Cette étape est donc essentielle car elle conditionne le positionnement des traces de matière fonctionnelle sur le substrat.

Les conditions de pression et de température seront donc avantageusement sélectionnées en fonction des matières A et B utilisées respectivement dans le produit d'impression et dans la pellicule d'application.

A titre illustratif, la température d'application du film est avantageusement située entre 0°C et 200°C, par exemple entre 70°C et 190°C, par exemple entre 110°C et 150°C ; une température comprise entre 120°C et 140°C représentant un bon compromis.

La présente invention est également décrite de manière illustrative et selon un de ses modes de réalisation dans la figure 3. On peut y voir sur la partie gauche de la figure, un groupe de dorure conforme à la présente invention et qui se trouve en aval du poste d'impression représenté sur la partie droite de la figure. Le substrat se déplace donc de droite à gauche. A titre illustratif, le substrat peut avantageusement être constitué de papier, de carton plat, de carton ondulé et/ou micro-ondulé et/ou de plastique. Il peut être sous forme de bobine - bobine ou de feuille à feuille. Lorsque le substrat passe sous le poste d'impression qui peut être un cylindre, un écran sérigraphique, et/ou des têtes jets d'encre, etc, le motif souhaité est imprimé par un vernis/une encre ou du toner contenant la matière A. Dans le cas de têtes jet d'encre, le vernis doit être adapté à ce type d'application en disposant d'une très basse viscosité. L'épaisseur imprimée peut avantageusement varier de 5 µm à 100 µm dans la majorité des cas ; elle peut néanmoins atteindre facilement plusieurs centaines microns.

Par la suite, le motif imprimé est réticulé au maximum de sa densité tridimensionnelle de ce que permet sa structure et ses sites de réaction ; ceci peut se faire par un moyen de séchage (comme représenté au centre de la figure) tel que séchage physique, IR, rayonnements UV, LED, etc. Le motif imprimé est après cette étape de séchage/réticulation non collant en surface.

Le groupe de dorure est dans cette illustration constitué d'au minimum deux rouleaux (de préférence motorisés), installés en vis-à-vis, tournant par exemple en sens contraire, et dont la distance est réglable de façon à s'adapter à différentes épaisseurs de substrats ; selon un mode d'exécution préféré de la présente invention, ce réglage tiendra compte non seulement de l'épaisseur du substrat mais également de l'épaisseur du produit d'impression (par exemple de l'encre et/ou du vernis) préalablement imprimé sur le substrat ainsi que de manière optionnelle en tenant compte des épaisseurs du film et donc des pellicules de la feuille de dorure déposées par le groupe de dorure. Selon un mode d'exécution particulier de la présente invention, l'écartement entre les rouleaux en vis-à-vis peut être motorisé et commandé de façon dynamique. Selon un mode d'exécution particulier et préféré de la présente invention, la surface du rouleau supérieur est différente de celle du rouleau inférieur ; en particulier, la surface du rouleau supérieur est plus compressible que celle du rouleau inférieur. A titre illustratif, le rouleau supérieur présente en surface une matière compressible lui permettant d'épouser la forme du motif imprimé du produit d'impression alors que le rouleau inférieur sera constitué d'une matière plus dure, par exemple incompressible. Selon un mode d'exécution particulier de la présente invention, le rouleau supérieur comporte un dispositif de chauffage permettant non seulement d'atteindre les températures de transition vitreuse Tg de chacune des matières A et B.

Selon un mode d'exécution particulier de la présente invention, le groupe de dorure (ou d'application du film) fonctionne avec une vitesse linéaire (en surface des rouleaux) supérieure ou égale à la vitesse du substrat sous le poste d'impression de façon à ne pas ralentir la machine.

Les caractéristiques de contrôle du groupe de dorure sont données ci-après à titre illustratif : pression réglable (par exemple de 1 à 10 bars, de préférence avec une pression de fonctionnement supérieure à 1 bar), et/ou vitesse réglable ; et/ou température réglable (par exemple une température de fonctionnement de maximum 250°C, par exemple comprise entre 0°C et 200°C, par exemple entre 70°C et 190°C, de préférence comprise entre 110°C et 150°C, par exemple comprise entre 120°C et 140°C ; et/ou dureté du revêtement du rouleau supérieur comprise entre 50 et 95 Shore A.

Le passage du motif imprimé (et réticulé) sous les rouleaux va permettre de chauffer le motif préimprimé contenant la matière A au-delà de la Tg de la matière A et du produit d'impression réticulé comprenant la dite matière A. Le caractère thermoplastique de la matière A va permettre un ramollissement de celle-ci. Il en est de même pour la matière B de la pellicule d'application. Les deux matières ainsi ramollies peuvent être considérées comme « ouvertes », permettant ainsi l'adhésion d'une matière analogue. Les groupements libres (par exemple hydroxylés) de chaque matière ainsi que les insaturations vont développer des liaisons chimiques de type covalente entre les matières. Ainsi, l'accroche de la matière B sur la matière A sera favorisée tout en évitant une quelconque accroche de la pellicule d'application sur les parties de substrat non préimprimées. La dépose sera ainsi dite « sélective ».

Dans un mode d'exécution particulier selon la présente invention, le décollement du foil (du film) du substrat se réalise idéalement lorsque le film est encore chaud afin d'être dans les meilleures conditions de transfert possible. La présence d'un angle ouvert lors du pelage du film permet d'obtenir une bonne finesse en évitant des contours mal définis.

Une composition particulière de film pouvant avantageusement être utilisé dans le cadre de la présente invention est décrite ci-dessous à titre illustratif et non limitatif.

Une couche de transport constituée de PET d'épaisseur de préférence comprise entre 15 µm et 24 µm (par exemple de 19µm), ce qui représente le meilleur compromis entre les propriétés mécaniques et sa faculté à conduire la chaleur lors de l'application du film.

Une pellicule de décollement avantageusement constituée de cire, par exemple d'une cire naturelle type carnauba, avec un point de fusion de préférence compris entre 60°C et 110°C (par exemple situé aux alentours de 85°C). Ainsi, suivant les conditions énoncées précédemment, lorsque la température d'application du film va atteindre les 120-140°C lors du dépôt, la cire sera vaporisée. Celle-ci étant le lien très fin (échelle nanométrique) entre les couches du film, sa transformation d'état va induire un détachement de la couche de transport vis-à-vis du reste du film.

La pellicule de protection peut avantageusement être composée de polymères acryliques hydroxylés de type PMMA et dérivés. La technologie repose le plus souvent sur la réaction bi composante des polymères hydroxylés avec des résines comportant des groupes isocyanates. Cette réaction va permettre de densifier le réseau polymérique dans l'optique d'améliorer les propriétés de résistance mécanique et chimique. Pour que cette couche soit conductrice des polymères de type PEDOT:PSS sont avantageusement introduits dans la matrice (voir exemple ci-dessous). 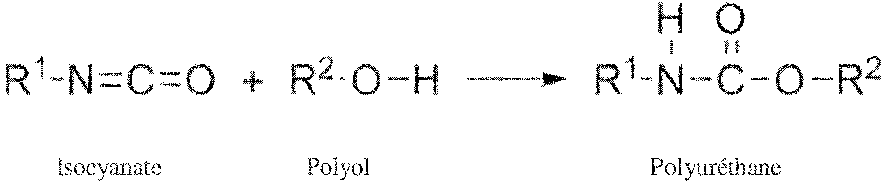 Avec R1 et R2 étant des chaines hydrocarbonées plus ou moins longues.

Une composition de 50% d'acrylique PMMA, 20% d'isocyanate et 30% de PEDOT:PSS est un bon équilibre afin d'obtenir les propriétés de résistance et de conductivité visées. La pellicule de matière fonctionnelle peut avoir plusieurs natures. L'exemple le plus performant est une nature métallique. L'aluminium reste un choix de meilleur compromis entre performance et prix vis-à-vis de l'argent et du cuivre. La matière fonctionnelle peut être composée d'un dépôt d'aluminium d'environ 1µm déposé par une technique PVD. Cette méthode d'évaporation sous vide est une technique de dépôt de couche mince, la matière vaporisée va venir se déposer de manière homogène sur le film/substrat. La valeur de résistance obtenue pour cette pellicule de matière fonctionnelle peut avantageusement se situer entre 0.3Ω et 10kΩ.

La pellicule d'application (comprenant et/ou constituée par la matière B) peut avantageusement être composée de résines acrylique et polyester hydroxylées, ainsi que de nitrocellulose et de charges. L'avantage que les résines acrylique et polyester soient hydroxylées et/ou carboxylées est la création de sites d'accroches favorisant les liaisons chimiques avec une interface mise en contact type matière A (provenant du produit d'impression). Une formule performante peut être composée de 40% de résine acrylique hydroxylée, 30% de résine polyester hydroxylée, 20% de nitrocellulose et 10% de charges type silice (%tage en poids). La formule finale sera de préférence une phase solvant d'extrait sec entre 15 et 30% en poids appliquée par rotogravure. Il est judicieux d'obtenir une Tg de la matière B dans une plage comprise entre 90 et 100°C.

Le produit d'impression peut-être avantageusement un vernis jet d'encre UV. Sa principale caractéristique est une faible viscosité comprise entre 5 mPa.s et 70 mPa.s, par exemple entre 10 mPa.s et 50 mPa.s. Il peut être composé de plusieurs monomères comme le dipropylène glycol dyacrilate (DPGDA), le trimethylolpropane triacrylate (TMPTA), la partie monomère représentant de préférence au moins 50% en poids de la composition du produit d'impression, par exemple 60% en poids. La partie photo initiateurs qui permet d'initier la réticulation est de préférence comprise entre 10 et 25% en poids de la composition du produit d'impression, par exemple de l'ordre 20% en poids ; elle est avantageusement composée d'alpha-hydroxy-cyclohexyl-phenyl-ketone et d'alpha-hydroxy ketone. La matière A est de préférence comprise entre 15 et 30% en poids de la composition du produit d'impression, par exemple 20% en poids ; il peut s'agir d'une résine acrylique hydroxylée dont la Tg est assez basse, environ 50°C.

L'objectif est donc de réactiver dans un premier temps le produit d'impression imprimé dès que la montée en température atteint la Tg du dit produit d'impression (par exemple entre 80°C - 90°C - et donc juste en dessous de la Tg de la pellicule d'application) ; ensuite, la température atteint la Tg de la pellicule d'application. Les groupes hydroxyles de la résine de la matière A seront autant de sites accrocheurs présents pour permettre une adhésion avec la matière B de la pellicule d'application.

### INTERACTIONS MATIERE A ET MATIERE B

Une gamme de températures susmentionnée permet de ramollir légèrement les matières A et B et, en particulier les produits d'impression et la pellicule d'application, grâce au dépassement de leur température de transition vitreuse Tg respective. Ces conditions seront sélectionnées pour permettre la création de liaisons chimiques entre les matières A et B et donc l'accroche améliorée et sélective entre le substrat et le film ; ces conditions seront également contrôlées de manière à éviter toute excursion/montée en température ce qui permet d'éviter
- que la matière B présente dans la pellicule d'application (et également la pellicule elle-même) ne devienne trop collante/fondue ; ce qui permet d'éviter toute adhésion de la pellicule d'application directement sur le substrat dans les zones non préimprimées de produit d'impression comprenant la matière A,
- que la matière A (et également le produit d'impression imprimé/réticulé lui-même) ne devienne trop collante/fondue ; ce qui permet d'éviter que le motif d'impression ne perde sa finesse et engendre des traces de matière fonctionnelle trop grossière et donc impropre à certaines utilisations telle que l'électronique imprimée.

Selon un mode d'exécution particulier de la présente invention, les matières A du produit d'impression et B de la pellicule d'application seront sélectionnées de manière à ce que la Tg de la matière A (Tg[A]) soit inférieure à la Tg de la matière B (Tg[B]) ; de préférence, Tg[A] sera inférieure à 0,9 Tg[B], voire inférieure à 0,8 Tg[B], par exemple inférieure à 0,7 Tg[B],

Selon un mode d'exécution particulier de la présente invention, les matières A du produit d'impression et B de la pellicule d'application seront sélectionnées de manière à ce que la Tg du produit d'impression (imprimé/réticulé) contenant la matière A soit inférieure à la Tg de la pellicule d'application contenant la matière B ; de préférence, Tg (produit d'impression (imprimé/réticulé)) sera inférieure à 0,95 Tg (pellicule d'application), voire inférieure à 0,9 Tg(pellicule d'application), par exemple inférieure à 0,85 Tg(pellicule d'application).

Selon un mode d'exécution particulier de la présente invention, les matières A du produit d'impression et B de la pellicule d'application seront sélectionnées de manière à ce qu'elles comprennent une nature chimique identique ; à titre illustratif et non limitatif, cette nature chimique sera sélectionnée parmi un groupe nucléophile (comprenant de l'oxygène et/ou de l'azote), un groupe hydroxyle et/ou un groupe azoté. Ceci favorisera la création de liaisons chimique de type covalente supérieure à 200kJ/mol entre les atomes afin de favoriser l'adhésion entre les surfaces du produit d'impression imprimé/réticulé et de la pellicule d'application.

Selon un mode d'exécution particulier de la présente invention, la Demanderesse a découvert de manière inattendue qu'il était possible d'optimiser les performances de dépôt de son procédé en contrôlant la température du produit d'impression après impression et avant application du film. Ainsi, dans une mode d'exécution préféré selon la présente invention une ou plusieurs des conditions citées ci-dessous est appliquée au procédé revendiqué
- la température de produit d'impression imprimé entre l'étape d'impression du dit produit et l'étape d'application du film est maintenue à une valeur supérieure à 35°C, par exemple supérieure à 40°C, de préférence supérieure à 45°C ; et/ou
- la température de produit d'impression imprimé et réticulé entre l'étape de réticulation du dit produit imprimé et l'étape d'application du film est maintenue à une valeur supérieure à 35°C, par exemple supérieure à 40°C, de préférence supérieure à 45°C.

Toutefois, même si cela ne représente pas un mode d'exécution préféré, il est évident que le procédé selon la présente invention couvre également le cas où l'étape d'application du film se ferait de manière déportée (dans le temps ou l'espace) par rapport à l'étape d'impression du produit d'impression.

Selon un mode d'exécution particulier de la présente invention, le procédé revendiqué comprend un procédé de dépôt de traces de matière fonctionnelle qui comprend également un procédé d'impression de traces isolantes en un seul passage dans la machine d'impression. Ainsi, le procédé revendiqué comprend non seulement l'impression d'un motif de premier produit d'impression comprenant la matière A conformément aux objectifs d'accroche de pellicule d'application et donc de matière fonctionnelle précités mais également l'impression d'un deuxième produit d'impression différent du premier produit d'impression utilisé ; ce deuxième produit d'impression sera sélectionné de manière à lui conférer une propriété isolante en terme de conduction électrique. Au-delà de sa propriété d'isolant, le deuxième produit d'impression sera sélectionné de manière à empêcher toute accroche avec la pellicule d'application du film ; ainsi, à titre illustratif, le deuxième produit d'impression ne comprend de préférence ni la matière A, ni aucune autre matière similaire a la matière A en terme de nature chimique et/ou propriétés physico-chimiques de manière à éviter l'affinité avec la matière B de la pellicule d'application. A titre illustratif et non limitatif, le deuxième produit d'impression sera sélectionné parmi les vernis thermodurcissables, de préférence UV-thermodurcissables - ils seront de plus de préférence exempts de tout polymère thermoplastique de Tg égale ou inférieure à la température d'application du film sur le substrat. Ce type de procédé grâce à l'utilisation d'un vernis foilable (conducteur et/ou isolant) et non foilable (conducteur et/ou isolant) ouvre un champ d'application intéressant pour l'électronique imprimée avec la possibilité d'imprimer des traces isolantes et/ou conductrices en un passage dans la machine d'impression en fonction du besoin client.

### INKJET CONDUCTEUR EN SERIE

Selon un mode d'exécution particulier de la présente invention, le procédé revendiqué comprend non seulement une étape d'impression de motif, suivie de l'étape de dépôt de traces de matière fonctionnelle selon le dit motif, mais il comprend également une étape additionnelle subséquente d'impression jet d'encre de produit d'impression conducteur au moins en partie sur les traces ou exclusivement sur les dites traces de matière fonctionnelle déposée. Ainsi, à titre illustratif, la présente invention permet aussi de rajouter un vernis conducteur jet d'encre en surface de la trace conductrice après l'application de la pellicule de matière fonctionnelle. L'avantage de ce vernis conducteur est multiple puisqu'il va permettre de préserver une conductivité élevée tout en apportant les propriétés de résistance mécanique et chimique d'un vernis de surface. Il s'intègre pleinement dans les problématiques observables dans le domaine de l'électronique imprimée.

Ce produit d'impression additionnel peut avantageusement être sélectionné parmi les vernis composés de polymères conducteurs tels que le polypyrrole, la polyaniline, le PEDOT:PSS, le polyacétylène et leurs dérivés, etc. L'ajout de charges métalliques ou carbonées afin d'améliorer cette conductivité est également possible. On citera également à titre illustratif des encres conductrices à base de nanoparticules conductrices comme des nanoparticules d'argent, de cuivre et/ou d'or.

Ces composés conducteurs peuvent être de différentes natures solvantés, aqueux ou UV ; leur séchage peut également être par rayonnement UV ou LED ou par séchage thermique ou IR.

On comprend de ce qui précède que la présente invention concerne également au moins un dispositif (ou un système) d'impression et/ou de personnalisation comprenant des moyens de mise en oeuvre d'au moins un des procédés décrits dans la présente demande. Grâce aux considérations fonctionnelles fournies dans la présente demande, on comprend que de tels systèmes ou dispositifs comportent des moyens d'accomplir les fonctions décrites en référence au procédé et qu'il n'est pas nécessaire de détailler ces moyens.

La présente demande décrit diverses caractéristiques techniques et avantages en référence aux figures et/ou à divers modes de réalisation. L'invention est définie par les revendications.

## Revendications

1. Procédé de dépôt de traces de matière fonctionnelle conductrice d'électricité sur un substrat dans une machine d'impression comprenant un poste d'impression suivi d'un poste de pose de film comprenant les étapes suivantes :
a. Fourniture du substrat,
b. Impression dans le poste d'impression d'un produit d'impression selon un motif sur le substrat, le produit d'impression comprenant une matière thermodurcissable et une matière A thermoplastique possédant une température de transition vitreuse Tg,
c. Fourniture d'un film comprenant au moins une pellicule d'application comprenant une matière B thermoplastique possédant une température de transition vitreuse Tg, une pellicule de matière fonctionnelle conductrice d'électricité et une couche de transport,
d. Application dans le poste de pose du film sur le substrat dans des conditions de pression et de température telles que les Tg de chacune des matières A et B sont atteintes et que des liaisons chimiques sont créées entre les matières A et B et entrainant la co-adhésion sélective entre le produit d'impression du motif et la pellicule d'application du film, et
e. Enlèvement du film du substrat,
e.1. le substrat comprenant la pellicule d'application du film co-adhérée au produit d'impression du motif et formant ainsi les traces de matière fonctionnelle conductrice d'électricité selon le dit motif, et
e.2. le reste de la pellicule fonctionnelle et, de préférence de la pellicule d'application, étant récupérée avec le film enlevé.

2. Procédé selon la revendication précédente **caractérisé en ce que** la pellicule d'application comprend au moins 50% en poids de la matière B thermoplastique, par exemple au moins 70% en poids, de préférence au moins 80% en poids.

3. Procédé selon l'une quelconques des revendications précédentes **caractérisé en ce que** la matière B thermoplastique est **caractérisée par** une valeur de Tg comprise entre 60°C et 130°C, de préférence entre 80°C et 120°C.

4. Procédé selon l'une quelconques des revendications précédentes **caractérisé en ce que** le produit d'impression comprend au moins 5% en poids de matière A thermoplastique, par exemple au moins 10 % en poids, de préférence au moins 15% en poids.

5. Procédé selon l'une quelconques des revendications précédentes **caractérisé en ce que** le produit d'impression comprend moins de 40% en poids, par exemple moins de 30% en poids, de préférence moins de 25% en poids de matière A thermoplastique.

6. Procédé selon l'une quelconques des revendications précédentes **caractérisé en ce que** le produit d'impression comprend au moins 60% en poids, par exemple au moins 70% en poids, de préférence au moins 75% en poids de matière thermodurcissable.

7. Procédé selon l'une quelconques des revendications précédentes **caractérisé en ce que** la matière A thermoplastique est **caractérisée par** une valeur de Tg inférieure à 60°C, par exemple inférieure à 50°C, de préférence inférieure à 40°C.

8. Procédé selon l'une quelconques des revendications précédentes **caractérisé en ce que** la Tg de la matière A (Tg[A]) est inférieure à la Tg de la matière B (Tg[B]).

9. Procédé selon la revendication précédente **caractérisé en ce que** Tg[A] est inférieure à 0,9 Tg[B], par exemple inférieure à 0,8 Tg[B], de préférence inférieure à 0,7 Tg[B],

10. Procédé selon l'une quelconques des revendications précédentes **caractérisé en ce que** l'étape d'application, dans le poste de pose, du film sur le substrat est effectuée à une température comprise entre 70°C et 190°C, par exemple comprise entre 110°C et 150°C, de préférence comprise entre 120°C et 140°C.

11. Procédé selon l'une quelconques des revendications précédentes **caractérisé en ce que** le produit d'impression est de type encre UV et/ou vernis UV.

12. Procédé selon l'une quelconques des revendications précédentes **caractérisé en ce que** le produit d'impression est réticulé après impression et avant application du film, de préférence à l'aide de LED et/ou de rayonnements UV.

13. Procédé selon l'une quelconques des revendications précédentes **caractérisé en ce que** la température de produit d'impression imprimé entre l'étape d'impression du dit produit et l'étape d'application du film est maintenue à une valeur supérieure à 35°C, par exemple supérieure à 40°C, de préférence supérieure à 45°C.

14. Procédé selon l'une quelconques des revendications précédentes **caractérisé en ce que** le produit d'impression est réticulé après impression et **en ce que** la température de produit d'impression imprimé et réticulé entre l'étape de réticulation du dit produit imprimé et l'étape d'application du film est maintenue à une valeur supérieure à 35°C, par exemple supérieure à 40°C, de préférence supérieure à 45°C.

15. Procédé selon l'une quelconques des revendications précédentes **caractérisé en ce que** la matière fonctionnelle de la pellicule de matière fonctionnelle comprend et/ou est constituée de cuivre et/ou d'argent, et/ou d'étain et/ou de chrome et/ou d'or et/ou d'aluminium, et/ou d'alliages conducteurs.

16. Procédé selon l'une quelconques des revendications précédentes **caractérisé en ce que** la pellicule de matière fonctionnelle a une épaisseur d'au moins 200 nm.

17. Procédé selon l'une quelconques des revendications précédentes **caractérisé en ce que** la pellicule de matière fonctionnelle a une épaisseur d'au moins 500 nm.

18. Procédé selon l'une quelconques des revendications précédentes **caractérisé en ce que** le film comprend une pellicule de décollement comprise entre la pellicule de matière fonctionnelle et la couche de transport.

19. Procédé selon la revendication précédente **caractérisé en ce que** la pellicule de décollement comprend et/ou est constituée de matière conductrice d'électricité, de préférence de polymères conducteurs.

20. Procédé selon l'une quelconques des revendications précédentes **caractérisé en ce que** le film comprend une pellicule de protection comprise entre la pellicule de matière fonctionnelle et soit la couche de transport, soit une pellicule de décollement comprise entre la pellicule de matière fonctionnelle et la couche de transport, la dite pellicule de protection comprenant et/ou étant constituée de matière conductrice d'électricité, de préférence de polymères conducteurs.

21. Procédé selon l'une quelconques des revendications 1 à 19 **caractérisé en ce que** le film ne comprend pas de pellicule de protection de la pellicule de matière fonctionnelle.

22. Procédé selon l'une quelconques des revendications précédentes **caractérisé en ce que** l'impression du produit d'impression est une impression en relief du motif d'impression effectuée par jet d'encre, de préférence à l'aide de têtes d'impression piézo-électriques.

23. Procédé selon l'une quelconques des revendications précédentes **caractérisé en ce qu'**il comprend également un procédé d'impression de traces isolantes en un seul passage dans la machine d'impression.

## Patentansprüche

1. Verfahren zur Aufbringung von Bahnen aus elektrisch leitfähigem Funktionsmaterial auf einem Substrat in einer Druckmaschine umfassend eine Druckstation gefolgt von einer Folienauflegestation, umfassend die folgenden Schritte:
a. Bereitstellung des Substrats,
b. Bedrucken eines Druckprodukts in der Druckstation gemäß einem Muster auf dem Substrat, wobei das Druckprodukt ein wärmehärtendes Material und ein thermoplastisches Material A mit einer Glasübergangstemperatur Tg umfasst,
c. Bereitstellung einer Folie umfassend mindestens einen Auftragsfilm umfassend ein thermoplastisches Material B mit einer Glasübergangstemperatur Tg, einen Film aus elektrisch leitfähigem Funktionsmaterial und eine Transportschicht,
d. Auftrag der Folie auf das Substrat in der Auflegestation unter solchen Druck- und Temperaturbedingungen, dass die Tg von jedem der Materialien A und B erreicht werden und dass chemische Bindungen zwischen den Materialien A und B erzeugt werden, die zu der selektiven Koadhäsion zwischen dem Druckprodukt des Musters und dem Folieauftragsfilm führen, und
e. Entfernen der Folie vom Substrat,
e.1. wobei das Substrat den Folieauftragsfilm umfasst, der mit dem Druckprodukt des Musters co-adhäsiv ist, und somit die Bahnen aus elektrisch leitfähigem Funktionsmaterial gemäß dem Muster bildet, und
e.2. mit der entfernten Folie wird der Rest des Funktionsfilms und vorzugsweise des Auftragsfilms zurückgewonnen.

2. Verfahren nach dem vorhergehenden Anspruch, **dadurch gekennzeichnet, dass** der Auftragsfilm mindestens 50 Gew.-% des thermoplastischen Materials B enthält, beispielsweise mindestens 70 Gew.-%, vorzugsweise mindestens 80 Gew.-%.

3. Verfahren nach einem der vorhergehenden Ansprüche, **dadurch gekennzeichnet, dass** das thermoplastische Material B durch einen Tg-Wert zwischen 60°C und 130°C, vorzugsweise zwischen 80°C und 120°C, gekennzeichnet ist.

4. Verfahren nach einem der vorhergehenden Ansprüche, **dadurch gekennzeichnet, dass** das Druckprodukt mindestens 5 Gew.-% des thermoplastischen Materials A, beispielsweise mindestens 10 Gew.-%, vorzugsweise mindestens 15 Gew.-%, enthält.

5. Verfahren nach einem der vorhergehenden Ansprüche, **dadurch gekennzeichnet, dass** das Druckprodukt weniger als 40 Gew.-%, beispielsweise weniger als 30 Gew.-%, vorzugsweise weniger als 25 Gew.-% des thermoplastischen Materials A., enthält.

6. Verfahren nach einem der vorhergehenden Ansprüche, **dadurch gekennzeichnet, dass** das Druckprodukt wenigstens 60 Gew.-%, beispielsweise mindestens 70 Gew.-%, vorzugsweise mindestens 75 Gew.-% des wärmehärtenden Materials, enthält.

7. Verfahren nach einem der vorhergehenden Ansprüche, **dadurch gekennzeichnet, dass** das thermoplastische Material A durch einen Tg-Wert von weniger als 60°C, beispielsweise weniger als 50°C, vorzugsweise weniger als 40°C, gekennzeichnet ist.

8. Verfahren nach einem der vorhergehenden Ansprüche, **dadurch gekennzeichnet, dass** die Tg von Material A (Tg[A]) kleiner ist als die Tg von Material B (Tg[B]).

9. Verfahren nach dem vorhergehenden Anspruch, **dadurch gekennzeichnet, dass** Tg[A] kleiner als 0,9 Tg[B], zum Beispiel kleiner als 0,8 Tg[B], vorzugsweise kleiner als 0,7 Tg[B], ist.

10. Verfahren nach einem der vorhergehenden Ansprüche, **dadurch gekennzeichnet, dass** der Schritt des Auftrags des Films auf das Substrat in der Auflegestation bei einer Temperatur zwischen 70°C und 190°C, beispielsweise zwischen 110°C und 150°C, vorzugsweise zwischen 120°C und 140°C, durchgeführt wird.

11. Verfahren nach einem der vorhergehenden Ansprüche, **dadurch gekennzeichnet, dass** das Druckprodukt vom UV-Tinten- und/oder UV-Lack-typ ist.

12. Verfahren nach einem der vorhergehenden Ansprüche, **dadurch gekennzeichnet, dass** das Druckprodukt nach dem Bedrucken und vor dem Auftrag der Folie vernetzt wird, vorzugsweise mit LEDs und/oder mit UV-Strahlung.

13. Verfahren nach einem der vorhergehenden Ansprüche, **dadurch gekennzeichnet, dass** die Temperatur des zwischen dem Schritt des Bedruckens des Produkts und dem Schritt des Auftragens der Folie bedruckten Druckprodukts auf einem Wert über 35°C, beispielsweise über 40°C, vorzugsweise über 45°C, gehalten wird.

14. Verfahren nach einem der vorhergehenden Ansprüche, **dadurch gekennzeichnet, dass** der Druckprodukt nach dem Bedrucken vernetzt ist, und dass die Temperatur des zwischen dem Schritt des Vernetzens des bedruckten Produkts und dem Schritt des Auftragens der Folie bedruckten und vernetzten Druckprodukts auf einem Wert über 35°C, beispielsweise über 40°C, vorzugsweise über 45°C, gehalten wird.

15. Verfahren nach einem der vorhergehenden Ansprüche, **dadurch gekennzeichnet, dass** das Funktionsmaterial des Films aus Funktionsmaterial aus Kupfer und/oder Silber und/oder Zinn und/oder Chrom und/oder Golden und/oder Aluminium und/oder leitfähigen Legierungen umfasst und/oder besteht.

16. Verfahren nach einem der vorhergehenden Ansprüche, **dadurch gekennzeichnet, dass** der Film aus Funktionsmaterial eine Dicke von mindestens 200 nm aufweist.

17. Verfahren nach einem der vorhergehenden Ansprüche, **dadurch gekennzeichnet, dass** der Film aus Funktionsmaterial eine Dicke von mindestens 500 nm aufweist.

18. Verfahren nach einem der vorhergehenden Ansprüche, **dadurch gekennzeichnet, dass** die Folie einen Trennfilm umfasst, die zwischen dem Film aus Funktionsmaterial und der Transportschicht enthalten ist.

19. Verfahren nach dem vorhergehenden Anspruch, **dadurch gekennzeichnet, dass** der Trennfilm aus elektrisch leitfähigem Material, vorzugsweise leitfähigen Polymeren, umfasst und/oder besteht.

20. Verfahren nach einem der vorhergehenden Ansprüche, **dadurch gekennzeichnet, dass** die Folie einen zwischen dem Film aus Funktionsmaterial und entweder der Transportschicht oder einem zwischen dem Film aus Funktionsmaterial und der Transportschicht enthaltenen Trennfilm enthaltenen Schutzfilm umfasst, wobei der Schutzfilm aus elektrisch leitfähigem Material, vorzugsweise leitfähigen Polymeren, umfasst und/oder besteht.

21. Verfahren nach einem der Ansprüche 1 bis 19, **dadurch gekennzeichnet, dass** die Folie keinen Schutzfilm zum Schutz des Films aus Funktionsmaterial umfasst.

22. Verfahren nach einem der vorhergehenden Ansprüche, **dadurch gekennzeichnet, dass** das Bedrucken des Druckprodukts ein mittels Tintenstrahl, vorzugsweise unter Verwendung von Piezo-Druckköpfen durchgeführter Reliefdruck des Druckmusters ist.

23. Verfahren nach einem der vorhergehenden Ansprüche, **dadurch gekennzeichnet, dass** es auch ein Verfahren zum Drucken von Isolierbahnen in einem einzigen Durchgang in der Druckmaschine umfasst.

## Claims

1. A method for depositing traces of electrically conductive functional material on a substrate in a printing machine comprising a printing station followed by a film-applying station, comprising the following steps:
a. providing the substrate,
b. printing, in the printing station, a printing product according to a pattern on the substrate, the printing product comprising a thermosetting material and a thermoplastic material A having a glass transition temperature Tg,
c. providing a film comprising at least one application film coating comprising a thermoplastic material B having a glass transition temperature Tg, a film coating of electrically conductive functional material and a transport layer,
d. applying, in the film-applying station, the film onto the substrate under pressure and temperature conditions such that the Tgs of each of the materials A and B are achieved and that chemical bonds are created between the materials A and B and leading to the selective co-adhesion between the pattern printing product and the application film coating, and
e. removing the film from the substrate,
e.1. the substrate comprising the application film coating co-adhered to the pattern printing product and thus forming the traces of electrically conductive functional material according to said pattern, and
e.2. the remainder of the film coating of functional material, and preferably of the application film coating, being recovered with the film removed.

2. The method as claimed in any of one of the preceding claims, **characterized in that** the application film coating comprises at least 50% by weight of the thermoplastic material B, for example at least 70% by weight, preferably at least 80% by weight.

3. The method as claimed in any one of the preceding claims, **characterized in that** the thermoplastic material B is **characterized by** a Tg value of between 60°C and 130°C, preferably between 80°C and 120°C.

4. The method as claimed in any one of the preceding claims, **characterized in that** the printing product comprises at least 5% by weight of the thermoplastic material A, for example at least 10% by weight, preferably at least 15% by weight.

5. The method as claimed in any one of the preceding claims, **characterized in that** the printing product comprises less than 40% by weight of the thermoplastic material A, for example less than 30% by weight, preferably less than 25% by weight.

6. The method as claimed in any one of the preceding claims, **characterized in that** the printing product comprises at least 60% by weight of the thermosetting material, for example at least 70% by weight, preferably at least 75% by weight.

7. The method as claimed in any one of the preceding claims, **characterized in that** the thermoplastic material A is **characterized by** a Tg value inferior to 60°C, for example inferior to 50°C, preferably inferior to 40°C.

8. The method as claimed in any one of the preceding claims, **characterized in that** the Tg value of the material A (Tg[A]) is inferior to the Tg value of the material B (Tg[B]).

9. The method as claimed in any one of the preceding claims, **characterized in that** Tg[A] is inferior to 0.9 Tg[B], for example inferior to 0.8 Tg[B], preferably inferior to 0.7 Tg[B].

10. The method as claimed in any one of the preceding claims, **characterized in that** the step of applying, in the applying station, the film onto the substrate is carried out at a temperature of between 70°C and 190°C, for example between 110°C and 150°C, preferably between 120°C and 140°C.

11. The method as claimed in any one of the preceding claims, **characterized in that** the printing product is a UV type ink and/or a UV type varnish.

12. The method as claimed in any one of the preceding claims, **characterized in that** the printing product is crosslinked after printing and before application of the film, preferably by means of LED and/or of UV radiation.

13. The method as claimed in any one of the preceding claims, **characterized in that** the temperature of the printed printing product between the step of printing said product and the step of applying the film is maintained at a value of greater than 35°C, for example greater than 40°C, preferably greater than 45°C.

14. The method as claimed in any one of the preceding claims, **characterized in that** the temperature of the printed and crosslinked printing product between the step of crosslinking said printed product and the step of applying the film is maintained at a value of greater than 35°C, for example greater than 40°C, preferably greater than 45°C.

15. The method as claimed in any one of the preceding claims, **characterized in that** the functional material of the film coating of functional material comprises and/or consists of copper and/or silver, and/or tin and/or chromium and/or gold and/or aluminum, and/or conductive alloys.

16. The method as claimed in any one of the preceding claims, **characterized in that** the film coating of functional material has a thickness of at least 200 nm.

17. The method as claimed in any one of the preceding claims, **characterized in that** the film coating of functional material has a thickness of at least 500 nm.

18. The method as claimed in any one of the preceding claims, **characterized in that** the film comprises a release film coating included between the film coating of functional material and the transport layer.

19. The method as claimed in the preceding claim, **characterized in that** the release film coating comprises and/or consists of electrically conductive material, preferably of conductive polymers.

20. The method as claimed in any one of the preceding claims, **characterized in that** the film comprises a protective film coating included between the film coating of functional material and, either the transport layer, or a release film coating included between the film coating of functional material and the transport layer, said protective film coating comprising and/or consisting of electrically conductive material, preferably of conductive polymers.

21. The method as claimed in any one of claims 1 to 19, **characterized in that** the film does not comprise a protective film coating for the film coating of functional material.

22. The method as claimed in any one of the preceding claims, **characterized in that** the printing of the printing product is relief printing of the printing pattern carried out by inkjet printing, preferably using piezoelectric printing heads.

23. The method as claimed in any one of the preceding claims, **characterized in that** it also comprises a method for printing insulating traces in a single pass in the printing machine.
